(19)

**Europäisches Patentamt**
**European Patent Office**
**Office européen des brevets**

(11) **EP 4 633 336 A1**

(12) **EUROPEAN PATENT APPLICATION**
published in accordance with Art. 153(4) EPC

(43) Date of publication:
**15.10.2025 Bulletin 2025/42**

(21) Application number: **23949988.2**

(22) Date of filing: **25.08.2023**

(51) International Patent Classification (IPC):
*H10K 50/805* (2023.01)

(52) Cooperative Patent Classification (CPC):
**H10K 50/805**

(86) International application number:
**PCT/CN2023/114979**

(87) International publication number:
**WO 2025/043393 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.
Beijing 100015 (CN)**
• **Yunnan Invensight Optoelectronics
Technology Co., Ltd.
Kunming, Yunnan 650211 (CN)**
• **Beijing BOE Technology Development Co., Ltd.
Beijing 100176 (CN)**

(72) Inventors:
• **LI, Guiqin
Beijing 100176 (CN)**
• **LEE, Yuhao
Beijing 100176 (CN)**
• **HUANG, Yinhu
Beijing 100176 (CN)**

• **ZHANG, Dacheng
Beijing 100176 (CN)**
• **CAI, Qinshan
Beijing 100176 (CN)**
• **SHEN, Xiaobin
Beijing 100176 (CN)**
• **WU, Cao
Beijing 100176 (CN)**
• **TONG, Hui
Beijing 100176 (CN)**
• **WANG, Huanhuan
Beijing 100176 (CN)**
• **MA, Yiwen
Beijing 100176 (CN)**
• **REN, Youtao
Beijing 100176 (CN)**
• **LI, Yulei
Beijing 100176 (CN)**
• **YANG, Ruibo
Beijing 100176 (CN)**
• **MA, Siyuan
Beijing 100176 (CN)**

(74) Representative: **Jacobacci Coralis Harle
32, rue de l'Arcade
75008 Paris (FR)**

(54) **DISPLAY PANEL AND DISPLAY APPARATUS**

(57)    Embodiments of the present disclosure provide a display panel comprising a plurality of subpixels, each subpixel comprising: a backplane; and a first electrode on the backplane, the first electrode comprising a center region and an edge region surrounding the center region, wherein the center region of the first electrode has a reflectivity different with a reflectivity of the edge region of the first electrode. Some embodiments of the present disclosure further provide a display device.

FIG. 3

EP 4 633 336 A1

## Description

FIELD

The present disclosure relates to the field of display technology and, in particular, to a display panel and a display device.

BACKGROUND

Currently, OLED (Organic Light-Emitting Diode) display panels are increasingly widely used. In OLED display panels, the light-emitting device usually includes a plurality of OLED light-emitting devices distributed in an array, and each light-emitting device can emit light independently in order to display an image.

However, the performance of OLED display panels still needs to be improved due to the manufacturing process.

BRIEF DESCRIPTION

Embodiments od the present disclosure provide a display panel and a display device.

According to an aspect of the present disclosure, there is provided a display panel including a plurality of subpixels, each of which may include: a backplane; and a first electrode on the backplane, the first electrode including a center region and an edge region surrounding the center region, wherein the center region of the first electrode has a reflectivity different with a reflectivity of the edge region of the first electrode.

In an exemplary embodiment of the present disclosure, each subpixel further may include: a pixel-defining layer on the backplane, the pixel-defining layer having an opening exposing a portion of the first electrode such that the first electrode has a first portion exposed by the opening and a second portion covered by the pixel-defining layer.

In an exemplary embodiment of the present disclosure, the center region of the first electrode may include a center region of the first portion and the edge region of the first electrode may include an edge region of the first portion, wherein the center region of the first portion may have a reflectivity less than a reflectivity of the edge region of the first portion.

In an exemplary embodiment of the present disclosure, the center region of the first electrode may include the first portion, and the edge region of the first electrode may include the second portion, and wherein the second portion of the first electrode may have a reflectivity less than a reflectivity of the first portion of the first electrode.

In an exemplary embodiment of the present disclosure, the first electrode may include: a first conductive layer on the backplane; a second conductive layer on a side of the first conductive layer away from the backplane; and a third conductive layer on a side of the second conductive layer away from the backplane, wherein the first conductive layer may have a reflectivity greater than a reflectivity of the second conductive layer and the third conductive layer.

In an exemplary embodiment of the present disclosure, the first conductive layer and the third conductive layer may be located in the first portion and the second portion of the first electrode and the second conductive layer may be located in the center region of the first portion and in the second portion.

In an exemplary embodiment of the present disclosure, the first conductive layer may include a stacked structure of at least one of a metal or alloy and a metal nitride, the second conductive layer may include a metal nitride, and the third conductive layer may include a transparent metal oxide.

In an exemplary embodiment of the present disclosure, the first conductive layer may include a stacked structure of a titanium layer, a titanium nitride layer and an aluminum layer, the second conductive layer may include a titanium nitride layer, and the third conductive layer may include an indium tin oxide layer.

In an exemplary embodiment of the present disclosure, the aluminum layer may include an aluminum alloy layer.

In an exemplary embodiment of the present disclosure, the aluminum alloy may have a different material in the center region of the first portion than in the edge region of the first portion such that a reflectivity of the aluminum alloy in the edge region of the first portion is greater than a reflectivity of the aluminum alloy in the center region of the first portion.

In an exemplary embodiment of the present disclosure, a thickness of the first conductive layer in the center region of the first portion may be less than a thickness of the first conductive layer in the edge region of the first portion.

In an exemplary embodiment of the present disclosure, a thickness of the aluminum layer in the center region of the first portion may be less than a thickness of the aluminum layer in the edge region of the first portion.

In an exemplary embodiment of the present disclosure, the first electrode may further include an antireflective or light-absorbing layer in the second portion and between the first conductive layer and the second conductive layer.

In an exemplary embodiment of the present disclosure, a surface of the first conductive layer away from the backplane includes a first sub-surface in the first portion and a second sub-surface in the second portion, wherein the second sub-surface has a roughness greater than a roughness of the first sub-surface.

In an exemplary embodiment of the present disclosure, a surface of the first conductive layer away from the backplane includes a first sub-surface in the first portion and a second sub-surface in the second portion, wherein the first sub-surface includes a center portion located at the center region of the first portion and an edge portion located at the edge region of the first portion and wherein the edge portion of the first sub-surface has a roughness less than a roughness of the center portion of the first sub-surface.

In an exemplary embodiment of the present disclosure, each subpixel may further include: a light-emitting functional layer on a side of the pixel-defining layer away from the backplane; and a second electrode on a side of the light-emitting functional layer away from the backplane.

In an exemplary embodiment of the present disclosure, a radius R of the center region of the first portion satisfies:

$R$=width of the opening of the pixel-defining layer - 2*thickness of the light-emitting functional layer*-$\tan\theta$,

where $\theta$ is an angle of incidence of light emitted from the light-emitting functional layer on the first electrode.

In an exemplary embodiment of the present disclosure, the second electrode may include a transparent layer and a transreflective layer.

In an exemplary embodiment of the present disclosure, the transparent layer may include a transparent metal oxide, and the transreflective layer may include a metal or an alloy.

In an exemplary embodiment of the present disclosure, the alloy layer may have a thickness of 10A-100A.

In an exemplary embodiment of the present disclosure, the subpixels may include a red subpixel, a green subpixel, and a blue subpixel, wherein the edge region of the first portion of the first electrode of the red subpixel has a reflectivity less than a reflectivity of the edge region of the first portion of the first electrode of the green subpixel and the edge region of the first portion of the first electrode of the blue subpixel.

In another aspect of the present disclosure, there is provided a display device including a display panel according to any one of embodiments relating to a display panel.

Further aspects and areas of applicability will become apparent from the description provided herein. It should be understood that various aspects of this application may be implemented individually or in combination with one or more other aspects. It should also be understood that the description and specific examples herein are intended for purposes of illustration only and are not intended to limit the scope of the present application.

## BRIEF DESCRIPTION OF THE DRAWINGS

The drawings described herein are for illustrative purposes only of selected embodiments and not all possible implementations, and are not intended to limit the scope of the present application, in which:

FIG. 1 schematically illustrates a cross-sectional view of an OLED display panel in the related art;
FIG. 2 schematically illustrates a microcavity effect for a single subpixel in an OLED display panel;
FIG. 3 schematically illustrates a cross-sectional view of a display panel in one or more embodiments of the present disclosure;
FIG. 4 schematically illustrates a cross-sectional view of a first electrode in one or more embodiments of the present disclosure;
FIG. 5 schematically illustrates a partition of a first electrode in one or more embodiments of the present disclosure;
FIG. 6 schematically illustrates a plan view of a first electrode in one or more embodiments of the present disclosure;
FIG. 7 schematically illustrates a plan view of a stack of the first electrode and a pixel-defining layer in one or more embodiments of the present disclosure;
FIG. 8 schematically illustrates a light-emitting functional layer having a stacked layer structure in one or more embodiments of the present disclosure;
FIG. 9 schematically illustrates a first electrode in another embodiment of the present disclosure; and
FIG. 10 schematically illustrates a display device according to one or more embodiments of the present disclosure.

Corresponding reference numerals indicate corresponding parts or features throughout the several views of the drawings.

## DETAILED DESCRIPTION

Various embodiments, which are provided as exemplary examples of the present disclosure, will now be described in detail with reference to the accompanying drawings to enable those skilled in the art to implement the present disclosure.

It should be noted that the following accompanying drawings and examples are not meant to limit the scope of the present disclosure. Where particular elements of the present disclosure may be partially or fully implemented using known components, only those parts of such known components that are necessary for an understanding of the present disclosure will be described, and the detailed descriptions of other parts of such known components will be omitted so as not to confuse the present disclosure. Further, various embodiments encompass present and future known equivalents to the components referred to herein by way of illustration.

As used herein, the expressions "have", "comprise" and "contain" as well as grammatical variations thereof are used in a non-exclusive way. Thus, the expression "A has B" as well as the expression "A comprises B" or "A contains B" may both refer to the fact that, besides B, A contains one or more further components and/or constituents, and to the case in which, besides B, no other components, constituents or elements are present in A. The terms "a", "an", "the", "said" and "at least one" are used to indicate the presence of one or more elements/components/etc.

As used herein, the term "be located on" does, however, not refer to a specific geometric orientation of the final stack in the display panel or the display device with respect to a direction of a gravitational force but rather indicates a way of manufacturing the stack, which, after manufacturing, could, in general, be placed in any geometric orientation, also such as turned upside down. The terms "first", "second", "third", etc. are used for descriptive purposes only and should not be construed to indicate or imply relative importance and order of formation.

In OLED display technologies, silicon-based OLEDs have the advantages of small size and high resolution. Silicon-based OLED adopts mature integrated circuit CMOS process, realizes active addressing of pixels, and has various circuits such as TCON and OCP, which is conducive to light weight. Silicon-based OLEDs are widely used in near-eye display and virtual reality and augmented reality, especially in AR/VR head-mounted display devices.

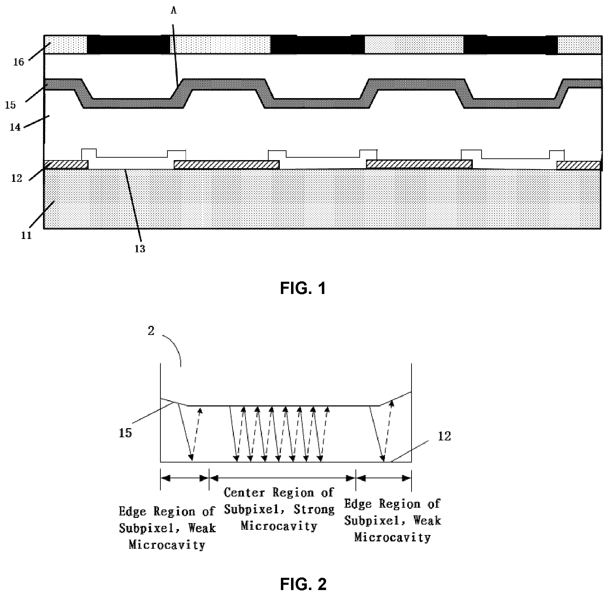

FIG. 1 schematically illustrates a cross-sectional view of an OLED display panel in the related art. As shown in FIG. 1, the OLED display panel may include a driving backplane 11, a plurality of first electrodes 12, a pixel-defining layer 13, a light-emitting function layer 14, a second electrode 15, and a color film layer 16. The first electrodes 16 are disposed in an array on the driving backplane 11; the pixel-defining layer 13 is disposed on a surface of the driving backplane 11 provided with the first electrodes 12 and has an opening exposing at least a portion of the respective first electrode 12; the light-emitting function layer 14 covers the pixel-defining layer 13 and surfaces of the first electrodes 12 away from the driving backplane 11, and the second electrodes 15 cover a surface of the light-emitting function layer 14 away from the driving backplane 11, so that a plurality of light-emitting devices may be defined by the pixel-defining layer 13. Driven by a drive signal, holes injected by the first electrodes 12 and electrons injected by the second electrode 15 enter the light-emitting function layer 14 and form excitons, and the excitons emit photons by radiative transition thereby forming electroluminescence. The color film layer 16 is disposed on a side of the second electrode 15 away from the driving backplane 11, and has a plurality of filtering zones corresponding one by one to each light-emitting device, and each filtering zone and its corresponding light-emitting device may act as a subpixel.

With the development and application of OLED display technology, especially micro OLED display technology, the requirements for the brightness of OLED products are getting higher and higher. In order to improve the brightness of each light-emitting device of the OLED, each component of the OLED is usually set up based on the microcavity principle. The first electrode 12, 14, the light-emitting functional layer, and 15 the second electrode may form a microcavity structure. A strong microcavity may be formed between the first electrode 12 and the second electrode 15 by reasonably setting the thickness between the first electrode 12 and the second electrode 15, thereby improving the luminous efficiency of the OLED display device.

The strong microcavity effect may be realized in the case of satisfying $\left| d - \dfrac{N\lambda}{2n} \right| = 0$, wherein $d$ is the distance between the first electrode 12 and the second electrode 15, $n$ is an effective refractive index of the medium between the first electrode 12 and the second electrode 15, $N$ is an integer greater than or equal to 0, and $\lambda$ is a central wavelength of outgoing light. According to the above formula, the strong microcavity effect mainly depends on the distance d between the first electrode 12 and the second electrode 15 and the central wavelength $\lambda$ of the outgoing light.

However, at least one of the first electrode 12 and the second electrode 15, especially the second electrode 15 which is usually used as a cathode, undergoes a change in morphology near the edge of each subpixel due to a manufacturing process or other factors. As shown in FIG. 1, the second electrode 15 may have a segment difference A at the edge of each subpixel, which results in the distance between the first electrode 12 and the second electrode 15 in the center region of each subpixel being inconsistent with the distance between the first electrode 12 and the second electrode 15 in the edge region of the corresponding subpixel. On the other hand, due to the possibility of crosstalk between adjacent subpixels, this results in that the central wavelength of the edge region of the subpixel may be different from the central wavelength of the center region. Therefore, in the case where the strong microcavity condition is satisfied in the center region of each subpixel, the edge region no longer satisfies the strong microcavity condition because the distance between the first electrode 12 and the second electrode 15 of the edge region of each subpixel and the central wavelength of the outgoing light in the edge region may change. Therefore, the edge region of the subpixel is a weak microcavity region. FIG. 2 schematically illustrates a microcavity effect for a single subpixel in an OLED display panel. As shown in FIG. 2, a strong microcavity region is present in the center region 21 of the subpixel 2, while a weak microcavity region is present in the edge region 22 of the subpixel. This results in a lower light output efficiency in the edge region 22 of the subpixel.

Further, an electric field between the first electrode 12 and the second electrode 15 in the edge region of the subpixel may be different from the electric field between the first electrode 12 and the second electrode 15 in the center region due to variation in the electrode morphology. This variation of the electric field may likewise affect the light output efficiency in the edge region of each subpixel. Variation of the electric field due to changes in the morphology of the electrodes at the edges of the subpixels may also cause some light to change its direction and thus exit from a neighboring subpixel or from a non-luminous region between two neighboring subpixels, which may result in crosstalk phenomena.

Furthermore, as shown in FIG. 1, since the first electrode 12 generally extends to the non-effective light-emitting region of the subpixel (corresponding to the region covered by the pixel-defining layer) and the second electrode 15 is a continuous film layer, this results in the existence of an electric field in the non-effective light-emitting region of the subpixel as well, which causes the light-emitting functional layer 14 in the non-effective light-emitting region to emit a certain amount of light as well. A portion of the light emitted in this non-effective light-emitting region may exit from this non-effective light-emitting region under the microcavity structure formed by the first electrode 12 and the second electrode 15, which is generally not expected.

Embodiments of the present disclosure provide a display panel and a display device in which the first electrode has different reflectivity in different regions corresponding to each pixel, which not only improves the uniformity of light emitted from the effective light-emitting region of a pixel (corresponding to an opening region of the pixel-defining layer), but also reduces the light emitted from the non-effective light-emitting region between pixels.

In some embodiments of the present disclosure, a display panel is disclosed including a plurality of subpixels, each subpixel may include a backplane and a first electrode disposed on the backplane, and the first electrode may include a center region and an edge region surrounding the center region. A reflectivity of the center region of the first electrode may be different from a reflectivity of the edge region of the first electrode. Setting different reflectivity in different regions of the first electrode not only improves the uniformity of light emitted from the effective light-emitting region of the pixel, but also reduces the light emitted from the non-effective light-emitting region between the pixels.

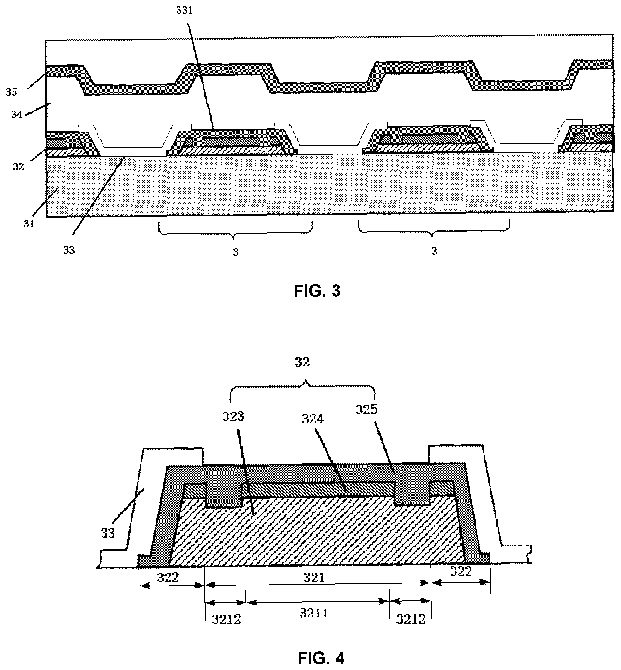

FIG. 3 schematically illustrates a cross-sectional view of a display panel in one or more embodiments of the present disclosure. As shown in FIG. 3, the display panel may include a plurality of subpixels 3, and each subpixel 3 may include a backplane 31, a first electrode 32 disposed on the backplane 31, a pixel-defining layer 33 disposed on a side of the first electrode 32 away from the backplane 31, a light-emitting function layer 34 disposed on a side of the pixel-defining layer 33 away from the backplane 31 and a second electrode 35 disposed on a side of the light-emitting function layer 34 away from the pixel-defining layer 33. In some embodiments of the present disclosure, each first electrode 32 may be dedicated to a corresponding subpixel 3, and the pixel-defining layer 33, the light-emitting function layer 34, and the second electrode 35 may be successive for a plurality of subpixels 3. That is, the plurality of subpixels 3 may share the pixel-defining layer 33, the light-emitting function layer 34, and the second electrode 35.

Various components of the display panel provided by embodiments of the present disclosure are described in detail below in connection with the accompanying drawings.

In some embodiments of the present disclosure, the backplane 31 may be a silicon-based backplane, which may include a substrate and a plurality of driving transistors provided on the substrate. The substrate may include a semiconductor material such as monocrystalline silicon or polycrystalline silicon. The driving transistors may be used to drive individual subpixels to emit light to display an image. The driving transistors may include an active region, an insulating layer, a gate, and a source/drain.

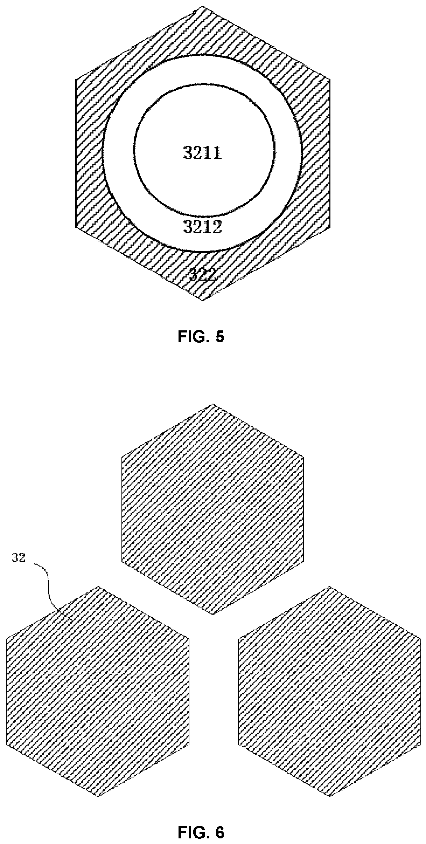

In some embodiments of the present disclosure, the plurality of first electrodes 32 may be distributed in an array on the backplane to correspond one-to-one with the plurality of subpixels. FIG. 4 schematically illustrates a cross-sectional view of a first electrode in one or more embodiments of the present disclosure, and FIG. 5 schematically illustrates a partition of a first electrode in one or more embodiments of the present disclosure. For illustrative purposes, a portion of the pixel-defining layer 33 is also shown in FIG. 4. As shown in FIGS. 4 and 5, each of the first electrodes 32 may have a second portion 322 that is covered by the pixel-defining layer 33 disposed thereon, and a first portion 321 that is exposed by an opening 331 of the pixel-defining layer 33. The first portion 321 may correspond to an effective luminescent region of the subpixel 3, and the first portion 321 may include a center region 3211 corresponding to a center region of the effective light-emitting region and an edge region 3212 corresponding to an edge region of the effective light-emitting region. The second portion 322 may correspond to a non-effective light-emitting region of the subpixel, i.e., a region covered by the pixel-defining layer.

FIG. 6 schematically illustrates a plan view of a first electrode in one or more embodiments of the present disclosure. As shown in FIG. 6, in some embodiments of the present disclosure, the first electrode 32 may be a hexagonal shape. **In** other embodiments, the first electrode 32 may also be other polygonal shapes, for example, a quadrilateral. **In** yet some more embodiments, the first electrode 32 may also be an irregular shape.

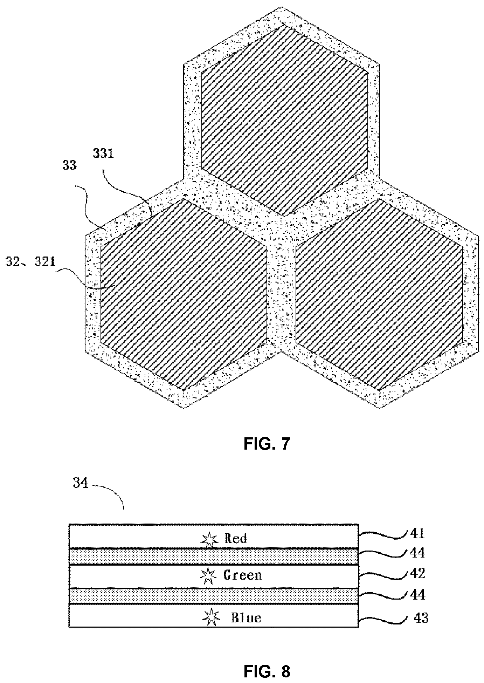

FIG. 7 schematically illustrates a plan view of a stack of the first electrode and the pixel-defining layer in one or more embodiments of the present disclosure. As shown in FIG. 7, the pixel-defining layer 33 is disposed on the first electrode 32 and covers the second portion 322 of the first electrode 32 and exposes the first portion 321 of the first electrode 32 through the opening 331. **In** some embodiments, the opening 331 of the pixel-defining layer 33 may have the same shape as the first electrode, but a size of the opening of the pixel-defining layer 33 may be smaller than a size of the first electrode 32 such that the first electrode 32 is not fully exposed by opening 331 of the pixel-defining layer 33. **In** other embodiments, the shape of the opening 331 of the pixel-defining layer 33 may be different from the shape of the first electrode 32.

**In** some embodiments of the present disclosure, the center region of the first electrode 31 may include a center region 3211 of the first portion 321 exposed by the opening of the pixel-defining layer, and the edge region of the first electrode 32 may include an edge region 3212 of the first portion 321 exposed by the pixel-defining layer 33. **In** some embodiments, the reflectivity of the center region 3211 of the first portion 321 may be less than the reflectivity of the edge region 3212 of the first portion 321.

With this configuration, the reflectivity of the edge region 3212 of the first portion 321 may be increased with respect to the center region 3211 of the first portion 321 so that more light from the edge region 3212 of the first portion 321 may be reflected toward the light outgoing side of the display panel, and thus, the light output efficiency of the edge region of the effective light-emitting region of the subpixel 3 may be increased. Thus, by increasing the reflectivity of the edge region 3212 of the first portion 321, the uniformity of the light output of the subpixels 3 of the display panel, and thus the display effect, may be improved.

**In** some embodiments of the present disclosure, a thickness of the edge region 3212 of the first portion 321 may be smaller than a thickness of the center region 3211 of the first portion 321. Typically, reducing the thickness of the edge region 3212 of the first portion 321 compared to the center region 3211 of the first portion 321 may increase the reflectivity of the edge region 3212 of the first portion 321.

**In** some embodiments of the present disclosure, the first electrode 32 typically includes a multilayer structure in order for the first electrode 32 to have good electrical conductivity, good chemical and morphological stability, and a high work function. **In** an example embodiment, the first electrode 32 may include a first conductive layer 323 disposed on the backplane 31, a second conductive layer 324 disposed on a side of the first conductive layer 323 away from the backplane 31, and a third conductive layer 325 disposed on a side of the second conductive layer 324 away from the backplane 31. **In** some embodiments, as shown in FIG. 4, the first conductive layer 323 and the third conductive layer 325 may be located in the first portion 321 and the second portion 322 of the first electrode 32, and the second conductive layer 324 may be located only in the center region 3211 of the first portion 321 and in the second portion 322. That is, for a single subpixel 3, both the first conductive layer 323 and the third conductive layer 325 are continuous, while the second conductive layer 324 is disconnected in the edge region 3212 of the first portion 321, such that the second conductive layer 324 is located only in the center region 3211 of the first portion 321 and in the second portion 322, but there is no the second conductive layer 324 in the edge region 3212 of the first portion 321. Typically, the first conductive layer may have a reflectivity greater than the second and third conductive layers. By not having the second conductive layer in the edge region of the first portion of the first electrode, the absorption of light by the second conductive layer in the edge region of the first portion may be reduced, which allows more light to be incident on the first conductive layer and to be reflected by the first conductive layer. As a result, the reflection of light by the first electrode, specifically the first conductive layer of the first electrode, in the edge region of the first portion may be increased, such that the brightness of subpixels in the edge region of the effective opening region may be increased.

**In** some embodiments of the present disclosure, the third conductive layer 325 may fill a notch formed by the second conductive layer 324 in the edge region 3212 of the first portion 321 due to disconnection. In some embodiments, a thickness of the third conductive layer 325 at the notch is equal to a sum of a thickness of the second conductive layer 324 and a thickness of the third conductive layer 325 at other locations such that a surface of the third conductive layer 325 away from the backplane 31 may be planar. In other embodiments, the thickness of the third conductive layer 325 at the notch is less than the sum of the thickness of the second conductive layer 324 and the thickness of the third conductive layer 325 at the other locations to allow the surface of the third conductive layer 325 away from the backplane 31 to have a depression at the notch towards the notch.

In an example embodiment, the first conductive layer 323 may include a metal layer, such as a single-element metal layer having a high work function, such as, for example, aluminum, silver, titanium, barium. In another example embodiment, the first conductive layer 323 may include a stacked structure of a metal and a metal nitride, such as, for example, a stacked structure of a titanium layer, a titanium nitride layer, and an aluminum layer, i.e., Ti/TiN/Al. As an example, the thicknesses of the titanium layer, the titanium nitride layer, and the aluminum layer of the stacked structure may be 200 A, 100 A, and 700 A, respectively. In some embodiments, the aluminum layer may include an aluminum alloy layer, for example, an aluminum-copper alloy. With the first conductive layer 323 using the metal layer or the stacked structure having the plurality of layers including a metal or a metal alloy, the first conductive layer 323 may have a high reflectivity. In some embodiments of the present disclosure, the first conductive layer 323 may serve as a primary reflective layer of the first electrode 32.

In an example embodiment, the second conductive layer 324 may include a metal nitride, such as a titanium nitride layer. Using titanium nitride as the second conductive layer 324 of the first electrode 32 may increase the work function and contribute to hole injection. As an example, the second conductive layer 323 may have a thickness of 15A.

The third conductive layer 325 may include a transparent metal oxide, such as ITO, ZnO, AZO (Al:ZnO). In some embodiments, the third conductive layer 325 may cover the second conductive layer 324 and the first conductive layer 323 and extend over the backplane 31 at a slope to encapsulate the first conductive layer 323 and the second conductive layer 324 together with the backplane 31. In some embodiments, the third conductive layer 325 may also include a first transparent metal oxide layer and a second transparent metal oxide layer. In an example embodiment, the second transparent metal oxide layer may have a thickness of about three times a thickness of the first transparent metal oxide layer. As an example, the thickness of the first transparent metal oxide layer may be 50A and the thickness of the second transparent metal oxide layer may be 150A.

In some embodiments of the present disclosure, a material of the first conductive layer 323 may be different in the center region 3211 of the first portion 321 than in the edge region 3212 of the first portion 321 such that the reflectivity of the first conductive layer 323 in the edge region 3212 of the first portion 321 is greater than the reflectivity of the center region 3211 of the first portion 321. In an example embodiment, the first conductive layer 323 uses a different aluminum alloy material in the edge region 3212 of the first portion 321 than in the center region 3211 of the first portion 321. As an example, the aluminum alloy layer of the first conductive layer 323 may use an aluminum-copper alloy in the central region 3211 of the first portion 321, and the aluminum alloy layer of the first conductive layer 323 may use an aluminum-silver alloy in the edge region 3212 of the second portion 321.

In a further embodiment, in order to further improve the reflectivity of the edge region 3212 of the first portion 321 of the first electrode 31, the thickness of the first conductive layer 323 in the center region 3211 of the first portion 321 may be less than the thickness of the first conductive layer 323 in the edge region 3212 of the first portion 321. In the embodiment where the first conductive layer 323 includes a stacked structure of a titanium layer, a titanium nitride layer, and an aluminum layer, i.e., Ti/TiN/Al, it may be possible to make the thickness of the aluminum layer at the center region 3211 of the first portion 321 less than the thickness of the aluminum layer at the edge region 3212 of the first portion 321. As an example, the thicknesses of the titanium layer, the titanium nitride layer, and the aluminum layer at the center region 3211 of the first portion 321 may be 200 A, 100 A, and 700 A, respectively, and the thicknesses of the titanium layer, the titanium nitride layer, and the aluminum layer at the edge region 3212 of the first portion 321 may be 200 A, 100 A, and 500 A, respectively. Typically, for a reflective layer, the greater the thickness, the greater the reflectivity is, so increasing the thickness of the first conductive layer 323 of the edge region 3212 of the first portion 321 may increase the reflectivity of the edge region 3212 of the first portion 321, thereby increasing the light output efficiency of the edge region of the effective opening region of the subpixel 3 to ensure the uniformity of light output of the entire subpixel 3.

In embodiments of the present disclosure in which the reflectivity of the first conductive layer of the first electrode 32 is greater than the reflectivity of the second conductive layer and the third conductive layer, a surface of the first conductive layer away from the backplane may include a first sub-surface disposed in the first portion and a second sub-surface disposed in the second portion, and the first sub-surface may include a center portion disposed in the center region of the first portion and an edge portion disposed in an edge region of the first portion. In some embodiments of the present disclosure, a roughness of the edge portion of the first sub-surface of the first conductive layer 323 may be less rough than a roughness of the center portion of the first sub-surface. Typically, the greater the roughness, the higher the reflectivity. Thus, by making the roughness of the edge portion of the first sub-surface smaller than the roughness of the center portion of the first sub-surface, it is possible to allow the reflectivity of the edge portion of the first surface to be larger than the reflectivity of the center portion of the first sub-surface so that the reflectivity of the center region 3211 of the first portion 321 is smaller than the reflectivity of the edge region 3212 of the first portion 321.

As an example, in the process of forming the first conductive layer 323 by a dry etching process, a surface of the first conductive layer 323 in the edge region 3212 of the first portion 321 (i.e., the edge portion of the first sub-surface) may be smoothed to increase the reflectivity of the first conductive layer 323 in the edge region 3212 of the first portion 321.

As already described above, each subpixel 3 may further include a light-emitting functional layer 34 located on the side of the pixel-defining layer 33 away from the backplane 31.

In some embodiments, the light-emitting functional layer 34 may include a hole injection layer, a hole transport layer, a light-emitting layer, an electron transport layer, and an electron injection layer.

In other embodiments, in order to improve the brightness and extend the service life, a stacked structure of multiple light-emitting function sub-layers is usually used to achieve a color display by means of white light plus a color film layer. The light-emitting function layer 34 may include a plurality of light-emitting function sub-layers arranged in a stack, and each light-emitting function sub-layer may include a hole injection layer, a hole transport layer, a light-emitting layer, an electron transport layer, and an electron injection layer. A charge generation layer is provided between two adjacent light-emitting function sub-layers, and the charge generation layer allows the plurality of light-emitting function sublayers to be connected in series, thereby forming a series-connected OLED light-emitting device. FIG. 8 schematically illustrates a light-emitting functional layer having a stacked layer structure in one or more embodiments of the present disclosure. As shown in FIG. 8, the light-emitting functional layer may include a first light-emitting functional sublayer 41, a second light-emitting functional sublayer 42, and a third light-emitting functional sublayer 43 connected in series via a charge generating layer 44, with the first light-emitting functional sublayer 41 emitting red light, the second light-emitting functional sublayer 42 emitting green light, and the third light-emitting functional sublayer 43 emitting blue light. In order to make such a series-connected OLED light-emitting device emit colored light, a color film layer may be provided on the light output side so that the series-connected OLED light-emitting device is pixelated into red subpixels, green subpixels, and blue subpixels.

As described above, in the series-connected OLED light-emitting device, a charge generating layer is usually provided between the light-emitting functional layers of different colors to provide carriers to the light-emitting functional layers on both sides thereof. However, since the charge generating layer is usually a highly conductive material with a high carrier migration rate, it is prone to cause leakage between neighboring pixels. This may lead to light outgoing in the non-luminous regions between neighboring pixels as well, thus causing crosstalk between pixels.

In addition, as previously mentioned, changes in the electric field in the edge region of the subpixel 3 may occur due to manufacturing process or other factors. These factors may cause light to be generated in the non-luminous region between neighboring subpixels 3 as well. If the light is reflected back and forth between the first electrode 32 and the second electrode 35 in the non-luminous region, a portion of the light will also exit from the non-luminous region between the neighboring subpixels 3 or be reflected toward the neighboring subpixel, thereby causing crosstalk, which is generally undesirable. Therefore, it is desired to reduce the reflectivity of the first electrode 32 in the second portion 322 covered by the pixel-defining layer to reduce the amount of light that exits from the non- luminous region between the neighboring subpixels 3 or is emitted to the neighboring subpixel.

Thus, as an alternative or addition to some of the above embodiments, the edge region of the first electrode 32 further includes a second portion 322 of the first electrode 32 covered by the pixel-defining layer 33, which second portion 322 has a reflectivity that is less than the reflectivity of the first portion 321 and, in particular, is less than the reflectivity of the center region 3211 of the first portion 321. By reducing the reflectivity of the second portion 322 of the first electrode 32 compared to the first portion 321 of the first electrode 32, undesired light exiting from the non-luminous region between the subpixels 3 or being reflected to the neighboring subpixel 3 may be reduced.

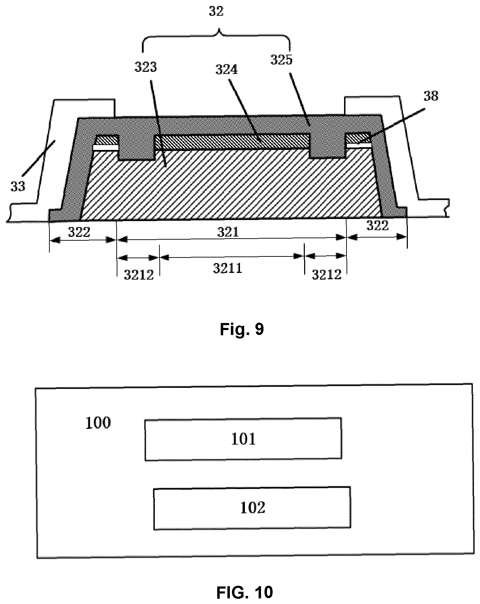

In some embodiments, to reduce the reflectivity of the second portion 322 of the first electrode 32, an anti-reflective layer or a light-absorbing layer may be provided at the second portion 322 of the first electrode 32. FIG. 9 schematically illustrates a first electrode in another embodiment of the present disclosure. As shown in FIG. 9, an anti-reflective layer and a light-absorbing layer 38 may be provided between the first conductive layer 323 and the second conductive layer 324. The anti-reflective layer or the light-absorbing layer 38 may reduce the reflection of light at the second portion 322 of the first electrode 32, thereby reducing the light exiting the region of the subpixel 3 corresponding to the second portion 322.

In other embodiments, in order to reduce the reflectivity of the second portion 322 of the first electrode 32, a first sub-surface, located at the first portion 321, and a second sub-surface, located at the second portion 322, of the surface of the first conductive layer 323 away from the backplane 31 may have different roughness. Specifically, the roughness of the second sub-surface may be greater than the roughness of the first sub-surface, and thus, the reflectivity of the second sub-surface may be less than the reflectivity of the first sub-surface, such that the reflectivity of the second portion 322 of the first electrode 32 is less than the reflectivity of the first portion 321.

As an example, during forming the first conductive layer 323 by the dry etching process, the second sub-surface of the first conductive layer 323 located in the second portion 322 may be roughened. Typically, for the same substance, the rougher the surface, the lower the reflectivity. Thus, roughening the second sub-surface of the first conductive layer 323 located in the second portion 322 may cause the first conductive layer 323 to have a lower reflectivity in the second portion 322, thereby reducing the amount of light that exits from the region of the subpixel 3 that corresponds to the second portion 322. In another example, the second sub-surface of the first conductive layer 323 in the second portion 322 may be patterned such that the second sub-surface has a different topography than the first sub-surface of the first conductive layer 323 in the first portion 321 so as to reduce the reflection of the light towards the outgoing side by the second sub-surface of the first conductive layer 323 in the second portion 322.

Returning to reference FIG. 3, each subpixel 3 may also include a second electrode 35 disposed on a side of the light-emitting feature 34 away from the backplane 31 In some embodiments of the present disclosure, the second electrode 35 may include a transparent layer and a transreflective layer. In some embodiments, the transreflective layer may be disposed on a side of the light-emitting functional layer away from the backplane, and the transparent layer may be disposed on the transreflective layer. The transreflective layer may transmit a portion of the light from the light-emitting functional layer for displaying an image. The transreflective layer may also reflect another portion of the light from the light-emitting functional layer toward the first electrode. When the distance between the first electrode 32 and the transreflective layer satisfies a strong microcavity condition, the intensity of the light output of the effective light-emitting region of each subpixel (especially the center region of the effective light-emitting region) may be increased.

In some examples, the transreflective layer may include a metal layer, especially a metal layer having a low work function, such as an Ag, Al, Li, Mg, Ca layer. In other examples, the transreflective layer may include a metal alloy layer, such as. In an optional embodiment, the transreflective layer may be made of a metal or alloy material with a low work function, such as a MgAg alloy, a LiAl alloy. The use of a metal alloy to form the transreflective layer may prevent oxidation, improve stability, extend service life, and the like. In some example embodiments, the thickness of the transreflective layer may be 10-100 A, especially 10-70 A. The reflectivity of the transreflective layer may be 30%-80%.

In some embodiments, the transparent layer may comprise a transparent metal oxide, such as, ITO, ZnO, AZO (Al:ZnO).

In some embodiments of the present disclosure, the first electrode may be an anode, and the second electrode may be a cathode.

In some situations, the display panel may have a reddish picture, which may be caused by more red light emanating from the red subpixels (especially the edge region of the red subpixels). In order to reduce the reddish phenomenon of the display panel, first electrodes having different reflectivity may be provided for subpixels of different colors. In an example embodiment, the reflectivity of the edge region of the first portion of the first electrode of the red subpixel may be less than the reflectivity of the edge region of the first portion of the first electrode of the green subpixel and the reflectivity of the edge region of the first portion of the first electrode of the blue subpixel, in order to reduce the amount of red light emitted from the edge region of the effective light-emitting region of the red subpixel, and thereby attenuate or even eliminate the reddish phenomenon of the display panel.

In some embodiments of the present disclosure, the display panel may further include other film layers not shown in the figures, such as, a first encapsulation layer, a color film layer, a second encapsulation layer, and a transparent cover. The first encapsulation layer may cover the second electrode, and by way of example, the first encapsulation layer may include two inorganic layers and an organic layer between the two inorganic layers. The color film layer is disposed on a side of the first encapsulation layer away from the second electrode, and includes light filtering area corresponding one-to-one with the first electrodes, and the light filtering areas has various colors, such as red, blue, and green. The second encapsulation layer may cover the color film layer, and its structure may be the same as that of the first encapsulation layer. A transparent cover may cover the second encapsulation layer, which may be made of glass or material.

In some embodiments of the present disclosure, a radius R of the center region 3211 of the first portion 321 (corresponding to the effective light-emitting region of the subpixel) is: R=width of the opening of the pixel-defining layer - 2*thickness of the light-emitting functional layer*$tan\theta$, wherein $\theta$ is an angle of incidence of light emitted from the light-emitting functional layer 34 at the first electrode 32. Within this radius R, the light output rate of the subpixel is relatively high because the distance between the first electrode 32 and the second electrode 35 satisfies the strong microcavity condition. Outside of this radius, the distance between the first electrode 32 and the second electrode 35 or the wavelength of the light does not satisfy the strong microcavity condition due to process conditions or other factors. Therefore, in some embodiments of the present disclosure, in order to improve the light output efficiency of the subpixel outside of this radius, the reflectivity of the edge region 3212, which is located outside of this radius, of the first portion 321 of the first electrode 32 is set to be larger, to increase the light output efficiency of the edge region of the subpixel 3, so as to improve the uniformity of the light output of the effective light-emitting region of the subpixel 3.

Embodiments of the present disclosure further provide a display device including a display panel according to one or more embodiments of the present disclosure, such as at least one display panel of one or more embodiments disclosed in detail above. Thus, for optional embodiments of the display device, reference may be made to embodiments of the display panel. FIG. 10 schematically illustrates a display device according to one or more embodiments of the present disclosure. As shown in FIG. 10, the display device 100 may include a display panel 101 described according to any of the embodiments of the present disclosure with respect to embodiments involving a display panel, and a drive circuit 102 providing a drive signal for driving the display panel.

The foregoing description of the embodiment has been provided for purpose of illustration and description. It is not intended to be exhaustive or to limit the application. Individual elements or features of a particular embodiment are generally not limited to that particular embodiment, but, where applicable, are interchangeable and may be used in a selected embodiment, even if not specifically shown or described. The same may also be varied in many ways. Such variations are not to be regarded as a departure from the application, and all such modifications are included within the scope of the application.

**Claims**

1. A display panel comprising a plurality of subpixels, each subpixel comprising:

   a backplane; and
   a first electrode on the backplane, the first electrode comprising a center region and an edge region surrounding the center region, wherein the center region of the first electrode has a reflectivity different with a reflectivity of the edge region of the first electrode.

2. The display panel according to claim 1, wherein each subpixel further comprises:
   a pixel-defining layer on the backplane, the pixel-defining layer having an opening exposing a portion of the first electrode such that the first electrode has a first portion exposed by the opening and a second portion covered by the pixel-defining layer.

3. The display panel according to claim 2, wherein the center region of the first electrode comprises a center region of the first portion and the edge region of the first electrode comprises an edge region of the first portion, and wherein the center region of the first portion has a reflectivity less than a reflectivity of the edge region of the first portion.

4. The display panel according to claim 2, wherein the center region of the first electrode comprises the first portion, and the edge region of the first electrode comprises the second portion, and wherein the second portion of the first electrode has a reflectivity less than a reflectivity of the first portion of the first electrode.

5. The display panel according to claim 3 or 4, wherein the first electrode comprises:

   a first conductive layer on the backplane;
   a second conductive layer on a side of the first conductive layer away from the backplane; and
   a third conductive layer on a side of the second conductive layer away from the backplane, wherein the first conductive layer has a reflectivity greater than a reflectivity of the second conductive layer and the third conductive layer.

6. The display panel according to claim 5, wherein the first conductive layer and the third conductive layer are located in the first portion and the second portion of the first electrode and the second conductive layer is located in the center region of the first portion and in the second portion.

7. The display panel according to claim 6, wherein the first conductive layer comprises a stacked structure of at least one of a metal or alloy and a metal nitride, the second conductive layer comprises a metal nitride, and the third conductive layer comprises a transparent metal oxide.

8. The display panel according to claim 7, wherein the first conductive layer comprises a stacked structure of a titanium layer, a titanium nitride layer and an aluminum layer, the second conductive layer comprises a titanium nitride layer, and the third conductive layer comprises an indium tin oxide layer.

9. The display panel according to claim 8, wherein the aluminum layer comprises an aluminum alloy layer.

10. The display panel according to claim 9, wherein the aluminum alloy has a different material in the center region of the first portion than in the edge region of the first portion such that a reflectivity of the aluminum alloy in the edge region of the first portion is greater than a reflectivity of the aluminum alloy in the center region of the first portion.

11. The display panel according to claim 8, wherein a thickness of the first conductive layer in the center region of the first portion is less than a thickness of the first conductive layer in the edge region of the first portion.

12. The display panel according to claim 11, wherein a thickness of the aluminum layer in the center region of the first portion is less than a thickness of the aluminum layer in the edge region of the first portion.

13. The display panel according to claim 5, wherein the first electrode further comprises an antireflective or light-absorbing layer in the second portion and between the first conductive layer and the second conductive layer.

14. The display panel according to claim 5, wherein a surface of the first conductive layer away from the backplane comprises a first sub-surface in the first portion and a second sub-surface in the second portion, and wherein the second sub-surface has a roughness greater than a roughness of the first sub-surface.

15. The display panel according to claim 5, wherein a surface of the first conductive layer away from the backplane comprises a first sub-surface in the first portion and a second sub-surface in the second portion, wherein the first sub-surface comprises a center portion located at the center region of the first portion and an edge portion located at the edge region of the first portion and wherein the edge portion of the first sub-surface has a roughness less than a roughness of the center portion of the first sub-surface.

16. The display panel according to claim 3 or 4, wherein each subpixel further comprises:

    a light-emitting functional layer on a side of the pixel-defining layer away from the backplane; and
    a second electrode on a side of the light-emitting functional layer away from the backplane.

17. The display panel according to claim 16, wherein a radius R of the center region of the first portion satisfies:

    R=width of the opening of the pixel-defining layer - 2*thickness of the light-emitting functional layer*$tan\theta$,
    where $\theta$ is an angle of incidence of light emitted from the light-emitting functional layer on the first electrode.

18. The display panel according to claim 16, wherein the second electrode comprises a transparent layer and a transreflective layer.

19. The display panel according to claim 18, wherein the transparent layer comprises a transparent metal oxide, and the transreflective layer comprises a metal or an alloy.

20. The display panel according to claim 19, wherein the alloy layer has a thickness of 10A-100A.

21. The display panel according to claim 3 or 4, wherein the subpixels comprise a red subpixel, a green subpixel, and a blue subpixel, wherein the edge region of the first portion of the first electrode of the red subpixel has a reflectivity less than a reflectivity of the edge region of the first portion of the first electrode of the green subpixel and the edge region of the first portion of the first electrode of the blue subpixel.

22. A display device comprising a display panel according to any one of claims 1 to 21.

**FIG. 1**

Edge Region of
Subpixel, Weak
Microcavity

Center Region of
Subpixel, Strong
Microcavity

Edge Region of
Subpixel, Weak
Microcavity

**FIG. 2**

**FIG. 3**

**FIG. 4**

3211

3212

322

FIG. 5

32

FIG. 6

331

33

32、321

FIG. 7

34

| ☆ Red | 41 |
| | 44 |
| ☆ Green | 42 |
| | 44 |
| ☆ Blue | 43 |

FIG. 8

**Fig. 9**

**FIG. 10**

## INTERNATIONAL SEARCH REPORT

| International application No. |
| --- |
| **PCT/CN2023/114979** |

### A. CLASSIFICATION OF SUBJECT MATTER

H10K50/805(2023.01)i

According to International Patent Classification (IPC) or to both national classification and IPC

### B. FIELDS SEARCHED

Minimum documentation searched (classification system followed by classification symbols)

IPC:H01L H10K

Documentation searched other than minimum documentation to the extent that such documents are included in the fields searched

Electronic data base consulted during the international search (name of data base and, where practicable, search terms used)

CNTXT, ENTXTC, DWPI, VEN: 有机显示, 有机发光, oled, 有机led, 电极, 阳极, 阴极, 外围, 周边, 边缘, 周围, 外周, 中心, 中央, 中部, 内侧, 部分, 区域, 位置, 反射, 不同, 相同, 不等, 相等, organic display, organic emitting, electrode, cathode, anode, periphery, edge, surrounding, central, inner, portion, section, position, reflect, differ, same, equal

### C. DOCUMENTS CONSIDERED TO BE RELEVANT

| Category* | Citation of document, with indication, where appropriate, of the relevant passages | Relevant to claim No. |
| --- | --- | --- |
| X | CN 108123064 A (CANON INC.) 05 June 2018 (2018-06-05) description, paragraphs 0027-0074, and figures 1-15 | 1-2, 4, 16-22 |
| A | CN 106654046 A (WUHAN CHINA STAR OPTOELECTRONICS TECHNOLOGY CO., LTD.) 10 May 2017 (2017-05-10) entire document | 1-22 |
| A | CN 113571555 A (SHENZHEN CHINA STAR OPTOELECTRONICS SEMICONDUCTOR DISPLAY TECHNOLOGY CO., LTD.) 29 October 2021 (2021-10-29) entire document | 1-22 |
| A | US 2022131110 A1 (CANON INC.) 28 April 2022 (2022-04-28) entire document | 1-22 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **03 April 2024** | **29 April 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/114979**

| Patent document cited in search report | | | Publication date (day/month/year) | Patent family member(s) | | | Publication date (day/month/year) |
|---|---|---|---|---|---|---|---|
| CN | 108123064 | A | 05 June 2018 | US | 2018151830 | A1 | 31 May 2018 |
| | | | | KR | 20180062362 | A | 08 June 2018 |
| | | | | JP | 2018092912 | A | 14 June 2018 |
| | | | | CN | 108123064 | B | 17 November 2020 |
| | | | | JP | 7062405 | B2 | 06 May 2022 |
| CN | 106654046 | A | 10 May 2017 | WO | 2018113019 | A1 | 28 June 2018 |
| | | | | US | 2018198093 | A1 | 12 July 2018 |
| | | | | CN | 106654046 | B | 14 August 2018 |
| CN | 113571555 | A | 29 October 2021 | WO | 2023279439 | A1 | 12 January 2023 |
| | | | | US | 2023016730 | A1 | 19 January 2023 |
| US | 2022131110 | A1 | 28 April 2022 | JP | 2022071601 | A | 16 May 2022 |
| | | | | KR | 20220056811 | A | 06 May 2022 |
| | | | | EP | 3993082 | A1 | 04 May 2022 |

Form PCT/ISA/210 (patent family annex) (July 2022)